# FASCICULE DE BREVET EUROPEEN

(11) **EP 0 531 177 B1**
(45) Date de publication et mention de la délivrance du brevet: **21.05.1997**
(21) Numéro de dépôt: 92402000.1
(22) Date de dépôt: 10.07.1992
(51) Int. Cl.: G06F 11/22

(54) **Procédé de réparation et outil de maintenance et d'aide à la réparation mettant en oeuvre le procédé**
Verfahren und Vorrichtung zur Fehlererkennung und Reparatur eines Datenverarbeitungssystems
Method and apparatus for fault detection and repair of a data processing system

(30) Priorité: 14.08.1991 FR 9110345
(43) Date de publication de la demande: 10.03.1993
(73) Titulaire: BULL S.A., 78430 Louveciennes (FR)
(72) Inventeur: Astier, Maurice, F-91000 Massy (FR); Bombled, Didier, F-92410 Ville d'Avray (FR); Lantenois, Daniel, F-91370 Verrieres le Buisson (FR); Marques, Pedro, F-78500 Sartrouville (FR); Richard, Claude, F-91790 Boissy sous Saint Yon (FR)

(56) Documents cités:
- EP-A- 0 082 722
- EP-A- 0 284 111
- I.E.E.E. SPECTRUM vol. 21, no. 2, Février 1984, New York, US, pp 36-42; T.S. LIU: 'Maintenance Processors for Mainframe Computers'
- IECON '86, Milwaukee, US, 29 Septembre-3 Octobre, 1986, A.H. AL-ANBAKI ET AL: 'An Experimental Microprocessor Testing System', pp 413-417

## Description

La présente invention concerne un procédé de réparation d'équipements électroniques de traitement de l'information mis en oeuvre par un outil de maintenance et d'aide à la réparation. Elle concerne également ledit outil qui utilise des programmes de tests implantés en mémoire sur la carte comportant l'unité centrale de traitement de l'équipement à réparer et comportant, entre autres, des moyens logiciels fonctionnant sur un microodinateur présentant une interface utilisateur et relié à la carte comportant l'unité centrale de traitement par l'intermédiaire d'une voie de télécommunication standard et des moyens matériels comprenant principalement une carte pilote, un adaptateur de bus et des bouchons de terminaison de test.

Jusqu'à présent la solution la plus utilisée pour effectuer la réparation de sous-ensembles électroniques, par exemple dans le domaine de la micro-informatique, des terminaux et des stations de travail, consistait à utiliser un testeur automatique dont le diagnostic est rapide et efficace, et qui permet de bien répondre à des besoins spécifiques en période de fabrication. Cependant un tel testeur n'autorise à effectuer qu'exclusivement des réparations centralisées, son coût, de plus est très élevé, et son utilisation est délicate, entre autres, lorsqu'il s'agit de réparer des cartes de circuit imprimé portant des composants montés en surface (CMS). Une solution plus opportune consiste à utiliser un analyseur de signatures par exemple l'analyseur PM2544 de chez PHILIPS. En effet, l'analyse de signature offre un bon moyen d'aide à la réparation en utilisation décentralisée. A partir d'un programme en mémoire (par exemple en PROM) des séquences de test sont générées, puis le nombre de transitions sur un signal donné est compté pour être ensuite comparé avec une "signature" relevée par rapport à une carte de référence. De telles manipulations peuvent être de manière avantageuse réalisées sans nécessiter une grande compétence de la part du technicien et ceci avec une bonne probabilité de réparation. Néanmoins, cette solution présente également les divers inconvénients suivants. Tout d'abord, chaque type de carte ayant son propre relevé de signatures, une modification ou une version nouvelle entraîne obligatoirement un nouveau relevé de signatures. De plus, un tel système est fermé, il est donc non (ou difficilement) transportable et est en outre peu ergonomique pour l'utilisateur.

Le document IEEE SPECTRUM, Vol.21 n^{º}2, Février 1984, pages 36-42 divulgue un dispositif de traitement de l'information qui comprend des fonctions intégrées pour le diagnostique et recouvrement de fautes. Ledit dispositif utilisant un processeur de maintenance dédié réalisant de la surveillance simultanée.

La documentation nécessaire à l'interprétation et au dépannage est stockée sur papier. Enfin, l'emploi d'un analyseur de signatures se révèle être également une solution coûteuse.

Le but de la présente invention est de proposer un procédé de réparation mis en oeuvre par un outil de maintenance et d'aide à la réparation qui ne présente pas les divers inconvénients des outils connus.

Pour cela, la présente invention, comme définie dans les présentes revendications, propose un procédé de réparation mis en oeuvre par l'outil de maintenance et d'aide à la réparation du genre mentionné dans le préambule est remarquable en ce que pour l'identification du plus petit composant changeable, en premier lieu est opérée une sélection du type de test, test préliminaire, tests automatiques ou tests manuels, d'une part, suivie dans le cas d'un test préliminaire ou de tests automatiques de l'émission de la commande de lancement correspondante assurant le dialogue par l'intermédiaire de la carte pilote, cette dernière émettant alors des trames qui sont analysées par le microordinateur pour que des messages liés auxdites trames soient affichés par l'intermédiaire de l'interface utilisateur et que soit provoqué le passage en mode réparation, soit pour le test préliminaire avec accès direct à une boucle de réparation dès le premier sous-test détecté en erreur, soit pour les tests automatiques avec accès à un menu de bouclages dès la fin d'un test si une erreur a été détectée, alors qu'une mise à jour statistique est automatiquement effectuée dans les deux cas lorsqu'un test est détecté "réparé" d'autre part suivie dans le cas de tests manuels de l'affichage par l'intermédiaire de l'interface utilisateur d'un diagramme des opérations successives à effectuer et de l'affichage pour examen de la documentation de réparation et des statistiques correspondantes, alors que la mise à jour des statistiques est effectuée par appel d'un menu spécifique aux tests manuels.

Ainsi, une carte est testée par ensembles fonctionnels qui peuvent être hiérarchisés, chacun de ces ensembles constitue un test Le test est décomposé en sous-tests pour affiner le diagnostic, en contrôlant une erreur spécifique au moyen d'une boucle de réparation associée.

Bien entendu et selon plusieurs variantes, les tests peuvent être également contenus dans le système d'entrée-sortie basique (BIOS) de la machine ou encore téléchargés en mémoire à partir du système BIOD ou des circuits de mémoires spécifiques. Le test préliminaire permet d'accéder directement à la documentation de réparation du sous-test détecté en erreur, il exécute ensuite la boucle de réparation de ce sous-test. Le test préliminaire est toujours le premier test exécuté après chaque mise sous tension, à la fin du processus de test, la pile du processeur est initialisée, le raffraîchissement mémoire activé et les variables utiles pour le dialogue avec la carte pilote également initialisées. Les autres tests proposent un menu de bouclages sur erreurs et offrent par conséquent une meilleure ergonomie d'utilisation.

De même, selon le présent procédé c'est la carte comportant l'unité centrale de traitement de l'équipement à réparer qui devient principalement outil de réparation permettant de mettre en oeuvre ledit procédé de réparation en utilisant les programmes de tests implantés dessus. De cette manière, il est avantageusement disposé de toute la puissance intrinsèque de ladite carte, c'est-à-dire de toute la performance du processeurs, de la capacité mémoire, de la vitesse d'horloge et des accès aux outils de développement caractéristiques aux produits de grande diffusion.

En outre, la convivialité, la facilité d'utilisation sont assurées par la connexion d'un autre microordinateur présentant l'interface utilisateur et relié à ladite carte par exemple par l'intermédiaire d'une voie V24 standard. C'est dans ce dernier microordinateur que réside le programme de réparation selon l'invention. Les moyens logiciels sont essentiellement constitués de disquettes fonctionnant sur le microordinateur et d'un jeu de mémoire (par exemple des PROMS) de tests implanté sur la carte comportant l'unité centrale de traitement de l'équipement à réparer lorsque les tests ne sont pas intégrés au système d'entrée-sortie basique (BIOS) ou ne sont pas téléchargés à partir dudit système (BIOS).

Les moyens matériels peuvent se voir également adjoindre un oscilloscope ou une sonde logique.

De plus, le procédé de réparation selon l'invention est universel, s'adaptant à tout type d'équipement électronique de traitement de l'information, puisqu'il s'applique à un outil standard. Enfin, cet outil est prévu pour répondre à différentes caractéristiques qui ne sont pas présentées dans leur ensemble par les différents outils connus. En premier lieu, il permet d'atteindre de très bonnes performances techniques, plus de 80 % des équipements sont réparés avec la méthode et ce pourcentage est très sensiblement augmenté au cours de la vie d'un équipement donné, grâce à un suivi des cartes réparées et à l'élaboration de statistiques locales et générales. Les cartes logiques sont réparées par identification du plus petit composant changeable par l'intermédiaire et en exploitant une simple interface utilisateur standard, d'usage aisé et convivial, en même temps qu'est autorisé l'accès aux réseaux de communication et donc aux bases d'informations.

Une compétence minimale est requise de son utilisateur et l'investissement nécessaire à son acquisition est faible comparé aux outils connus. Enfin, il permet de garantir les réparations durant toute la vie de l'équipement et peut être utilisé en tout point du globe, le plus près de l'utilisateur final afin de supprimer les attentes, les coûts de gestion (faible stock de composants pour la réparation et stock bien ciblé) ainsi que les coûts de transport.

De manière remarquable dans l'outil de maintenance et d'aide à la réparation mettant en oeuvre le procédé selon l'invention, la carte pilote fonctionne en mode asynchrone et comporte des moyens pour adapter la liaison série du microordinateur recevant une partie des moyens logiciels en un bus parallèle pour la connexion à l'équipement à réparer et des moyens de gestion d'un premier niveau de protocole entre le microordinateur recevant les moyens logiciels et ladite carte pilote et d'un second niveau de protocole entre ladite carte pilote et l'équipement à réparer.

Ainsi, la carte pilote réalise une adaptation série-parallèle entre le microordinateur et l'équipement à réparer conforme aux exigences de connexion (présence d'un bus de données, d'une liaison sélection de circuit et d'une liaison lecture/écriture) et autorise la gestion des deux niveaux de protocole à son entrée et à sa sortie. Son fonctionnement en mode asynchrone permet de s'affranchir avantageusement des problèmes inhérents aux différentes cartes à réparer, en particulier à la vitesse du processeur (4 MHz, 25 MHz, 33MHz, ...).

Selon une application préférée, les moyens logiciels fonctionnant sur le microordinateur comportent des moyens de stockage dynamiques contenant des fichiers de configuration, des fichiers de messages système et le procédé de réparation coopérant pour élaborer différentes fenêtres, interrogeables par l'intermédiaire de l'interface utilisateur et informant sur les opérations en cours, et pour présenter un menu de bouclages automatiquement proposé à l'utilisateur après détection d'un test en erreur ou sur activation d'une erreur déjà présente dans sa fenêtre.

Ainsi, le procédé de réparation qui fonctionne sur le microordinateur offre à l'utilisateur une bonne ergonomie d'emploi, celui-ci disposant entre autres d'un accès direct et automatique à la documentation de réparation et d'un accès automatique aux fonctions de mise à jour statistiques. Selon le procédé, il est utilisé différentes fenêtres de taille convenable (par exemple 255 lignes) pour informer l'utilisateur sur les opérations en cours : fenêtres, message, erreur, statistique, documentation de réparation, aide, ... . La partie visible des fenêtres correspond à la dernière page affichée (taille normale ou agrandissement d'une partie de la page : zoom). Des flèches permettent de se déplacer dans la fenêtre. Les différentes informations affichées dans ses fenêtres sont extraites de fichiers résidants sur le disque dur ou en mémoire et constituent une partie des moyens de stockage, le dialogue entre le microordinateur et la carte pilote étant établi par des trames incluant des numéros représentant un index de test, documentation, ... . Un menu de bouclages est automatiquement proposé à l'utilisateur lorsqu' une erreur est détectée.

Le procédé peut être également appliqué à la réparation de cartes analogiques au moyen de l'affichage d'une documentation de réparation. Les tests, dans ce cas, sont dits "manuels" car ils n'utilisent pas le dialogue avec la carte pilote. De plus, toujours dans ce cas, une demande de mise à jour statistique doit être effectuée par appel d'un menu spécifique pour ces cartes avec tests "manuels". Pour les autres tests (autres que "manuels"), le microordinateur déclenche automatiquement la mise à jour statistique après détection de la panne.

Les fichiers de configuration (machines, cartes, langages, ...) peuvent être de préférence contenus dans une disquette (constituant également une partie des moyens de stockage dynamiques) pour être lus ou modifiés. Un programme d'installation ajoute ces fichiers dans le répertoire de travail de l'utilisateur, puis autorise la mise à jour des méthodes disponibles pour le réparateur. Il peut contenir un jeu de mémoires PROM qui sera installé sur la carte à réparer.

Le procédé de réparation et les fichiers de messages système sont également de préférence contenus dans une disquette (constituant la dernière partie des moyens de stockage). Un programme d'installation copie ces fichiers dans un répertoire de travail une fois pour toute, en conservant néanmoins à l'esprit qu'une réinstallation peut être effectuée à tout moment, dans le cas d'une destruction des fichiers consécutive à une panne ou pour installer une nouvelle version du procédé.

En outre, une mesure de qualité peut être avantageusement réalisée dans le but de fournir une représentation concrète des problèmes de non-conformité de sorte qu'il soit possible de les évaluer avec objectivité et d'apporter les corrections nécessaires à l'amélioration de la fiabilité des équipements. Pour cela, dans le procédé de réparation, il est prévu de mémoriser dans des fichiers statistiques l'historique de l'intervention au cours de la réparation, ces fichiers sont alors de préférence de trois types :
- le fichier "tests" qui permet d'évaluer la qualité du procédé, en indiquant également les programmes de tests à améliorer.
- le fichier "composants" qui est une sorte de catalogue de l'ensemble des références des composants susceptibles d'être en panne pour un test donné, lesdites références étant stockées dans des tables. Ces tables indiquent également le pourcentage de composants remplacés par le réparateur de la filiale (donc de manière locale) ainsi que le pourcentage consolidé internationalement (donc représentatif de l'ensemble du réseau). Pour chaque erreur détectée, la table des composants relative au test est présentée au réparateur pour consultation. Lorsque la carte est réparée, la méthode affiche automatiquement cette même table pour incrémenter le nombre correspondant au composant responsable de la panne.
- le fichier "autres" qui est ouvert au réparateur pour l'enregistrement d'un composant détecté en erreur mais qui ne figure pas dans la table proposée. Lors du traitement international des fichiers statistiques sur le serveur, les fichiers "composants" et "autres" sont fusionnés et seuls les composants les plus souvent en défaut vont constituer le nouveau fichier "composants". De cette manière, les réparateurs verront ces composants apparaître dans la liste initiale à la place d'autres moins significatifs.

Le principe permet :
. l'élaboration de statistiques à partir de l'expérience du réparateur.
. de confirmer un diagnostic, simplement en visualisant le taux statistique qui donne la probabilité que chaque composant a d'être en panne dans un test donné.
. une centralisation des résultats pour l'analyse du comportement d'un produit pour en améliorer éventuellement sa fiabilité, pour optimiser les prévisions de stockage des composants pour la réparation, pour la rediffusion des statistiques globales aux réparateurs et pour la détermination des programmes de tests à améliorer.

De même, selon une application préférée, des circuits de mémoire spécifiques (par exemple des mémoires PROM), enfichables sur la carte comportant l'unité centrale de traitement de l'équipement à réparer, contiennent les programmes de tests qui contrôlent les différents ensembles fonctionnels, chacun de ces ensembles constituant un test, chaque test étant décomposé en sous-tests correspondant au contrôle d'une erreur spécifique au moyen d'une boucle de réparation, alors qu'un test préliminaire est réalisé à chaque mise sous tension pour diagnostiquer et réparer le noyau minimum nécessaire d'une part à l'accès d'une zone mémoire autorisant les différents tests et d'autre part pour assurer le dialogue avec le microordinateur par l'intermédiaire de la carte pilote.

Ainsi grâce à l'invention il est possible de réparer efficacement un équipement pour un investissement peu élevé sans que cette opération ne requiert de la part du technicien une grande compétence spécifique, celui-ci au contraire pourra s'autoformer lors de l'application et donc de l'utilisation du procédé. En outre, la documentation sur papier est supprimée puisqu'elle est par exemple accessible de manière directe et conviviale sur le disque dur et gérée par les moyens logiciels. Enfin, l'information statistique sur les composants et le suivi des cartes à réparer fournit une mesure significative de la qualité d'un équipement.

La description suivante en regard des dessins annexés, le tout donné à titre d'exemple non limitatif, fera bien comprendre comment l'invention peut être réalisée.

La figure 1 propose un schéma d'ensemble de l'outil de maintenance et d'aide à la réparation conforme à l'invention.

La figure 2 présente un schéma synoptique de la carte pilote utilisée dans l'outil de maintenance et d'aide à la réparation.

La figure 3 propose un exemple de schéma représentant les différentes étapes parcourues pour la mise en oeuvre de tests utilisant les fonctions internes de la carte pilote.

La figure 4 propose un exemple de schéma représentant les différentes étapes parcourues par le procédé de réparation selon l'invention mis en oeuvre par l'outil de maintenance et d'aide à la réparation.

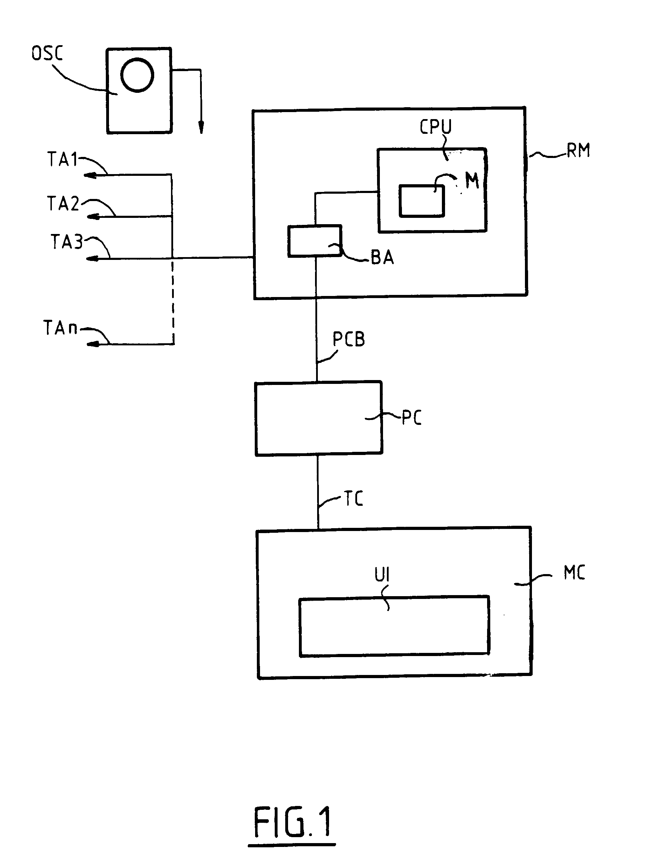

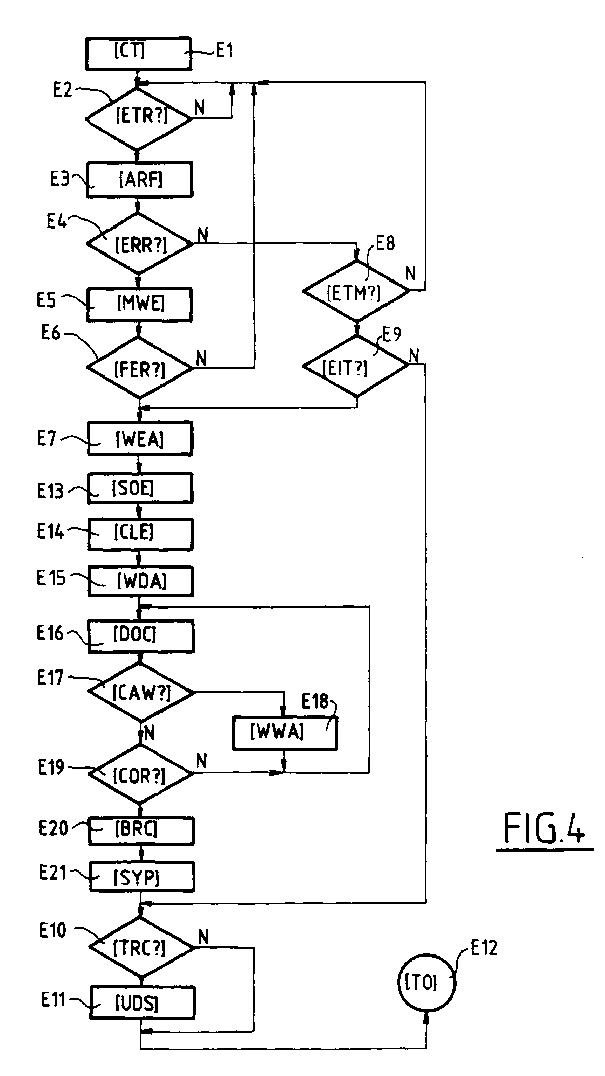

Sur la figure 1 est représenté de manière schématique l'outil de maintenance et d'aide à la réparation d'équipements électroniques RM de traitement de l'information mettant en oeuvre un procédé de réparation (décrit avec la figure 4) par identification du plus petit composant changeable. Sur la carte CPU de l'équipement RM à réparer qui comporte l'unité centrale de traitement , différents programmes de tests sont implantés par l'intermédiaire de mémoires spécifiques M, par exemple de type PROM, enfichables sur ladite carte CPU. L'outil comporte en outre des moyens logiciels, par exemple des disquettes contenant le programme de réparation fonctionnant sur un microordinateur MC utilisé comme superviseur présentant une interface utilisateur UI et relié à la carte CPU de l'équipement RM par l'intermédiaire d'une voie de télécommunication TC standard, par exemple du type V24 défini par le CCITT. L'outil comporte de plus des moyens matériels qui comprennent principalement une carte pilote PC fonctionnant en mode asynchrone, placée entre le microordinateur MC et reliée à celui-ci par l'intermédiaire de la voie TC et l'équipement à réparer RM et reliée à ce dernier au moyen du bus PCB, un adaptateur de bus BA pour adapter et configurer le bus dans l'équipement à réparer RM en facilitant avantageusement le dialogue et des bouchons de test TA₁, TA₂, TA₃, ..., TAₙ, pour simuler des sous-ensembles (clavier, imprimante, ...) ou adapter en impédance différentes prises terminales (clavier, imprimante, ...) de l'équipement RM. Un oscilloscope OSC ou une sonde logique peuvent être utilisés si nécessaire conjointement avec l'outil selon l'invention, par exemple pour comparer des signaux présents sur la carte à réparer avec des signaux décrits dans la documentation intégrée aux moyens logiciels et visualisés par l'intermédiaire de l'interface utilisateur UI.

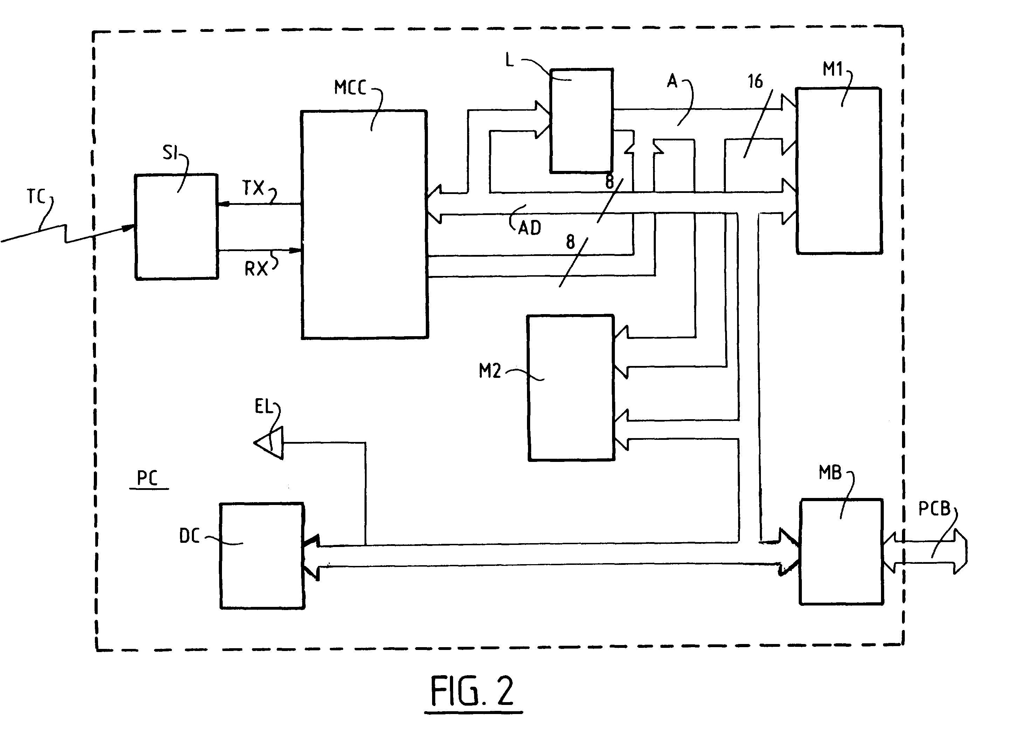

Sur la figure 2 est proposé un schéma synoptique de la carte pilote autorisant le dialogue entre le microordinateur et l'équipement à réparer.

Le dialogue entre le microordinateur MC (non représenté) et la carte pilote PC est permis grâce à la voie V24 référencée TC, voie asynchrone par laquelle sont transmises les informations (par exemple 8 bits à 9600 bauds) vers le circuit d'interface série SI. Le circuit d'interface SI opère une commutation de l'amplitude des signaux de + 15V, - 15V à 0V,5V pour les signaux émis par le microordinateur MC sur la voie TC et inversement de 0V, 5V à + 15V, - 15V pour les signaux à émettre vers le microordinateur MC. Le circuit SI est relié à un microcontrôleur MCC par exemple du type 8031 de chez INTEL par l'intermédiaire d'une double liaison série, l'une relative aux signaux à émettre TX, l'autre relative aux signaux reçus RX. Le microcontrôleur MCC comporte lui-même un contrôleur série et une mémoire vive de par exemple 128 octets dans laquelle sont stockées la pile et la mémoire de travail. Un bus de 8 bits multiplexé AD (adresses/données) permet de lire des informations ou instructions dans une mémoire morte M₁ par adressage de code contenant en particulier une fonction auto-test de la carte pilote automatique lancée à la mise sous-tension. Les 8 bits d'adresse du bus AD sont démultiplexés au moyen d'un circuit de verrouillage L de type "Latch" pour être transmis vers la mémoire M1 sur le bus d'adresses A. Le bus d'adresses A transmet également vers la mémoire M1 8 bits de poids supérieur en provenance du circuit MCC. Le bus A (16 bits) de même que le bus AD (8 bits) sont de plus connectés à une mémoire vive M2 par exemple de 8 Koctets servant de tampon pour les données dites de télécommunication émises ou reçues. En outre, le bus AD est relié d'une part à un circuit d'affichage DC et d'autre part à un circuit dit de boîte aux lettres MB. Le circuit DC permet alors de visualiser au moyen d'un afficheur le numéro du sous-test en cours, alors qu'une diode électroluminescente EL recevant un fil du bus AD est prévue pour indiquer, lorsqu'elle est active, qu'une erreur a été détectée. Le circuit de boîte aux lettres MB contenant essentiellement deux registres, l'un en écriture, l'autre en lecture sert d'interface pour autoriser le dialogue asynchrone entre la carte pilote PC et l'équipement à réparer RM reliés par l'intermédiaire du bus PCB.

Ainsi, la carte pilote PC fonctionnant en mode asynchrone permet avantageusement d'adapter la liaison série TC du microordinateur MC en un bus parallèle PCB pour la connexion à l'équipement à réparer RM et de gérer d'une part le premier niveau de protocole entre le microordinateur MC et elle-même et d'autre part le second niveau de protocole entre elle-même et l'équipement à réparer RM.

De façon remarquable et dans ce but, la mémoire M1 de la carte pilote PC contient des microprogrammes commandant différentes fonctions internes parmi lesquelles la fonction autotest effectue, à la mise sous tension, le test du fonctionnement de ladite carte PC avec rebouclage sur le sous-test en cours lors de la détection d'une erreur, la fonction d'affichage du code effectue la gestion des moyens d'affichage DC et EL pour indiquer, sur DC le numéro de sous-test en cours ainsi que sur EL l'apparition d'une erreur durant la séquence d'autotest, sur DC la réception d'une commande d'abandon d'un test ou d'un bouclage et sur DC et EL la détection d'une erreur sur une donnée reçue de ou à transmettre vers l'extérieur, la fonction initialisation initialise et active l'horloge interne, l'interface avec le microordinateur MC ou une interruption en réception, la fonction gestion de trames effectue l'extraction des données utiles et l'acquittement des trames reçues, la fonction analyse de trames procède à l'aiguillage vers les différentes phases du procédé de réparation en fonction de la commande à exécuter (test préliminaire, tests ou menu de bouclages, téléchargement, prise en compte et gestion d'une coupure), la fonction émission de trames opère l'encadrement par des caractères de contrôle des trames, l'émission des trames ainsi que l'attente d'acquittement des trames émises et la fonction dialogue procède à l'échange d'informations au travers du circuit de boîte à lettres MB accessible en lecture et en écriture.

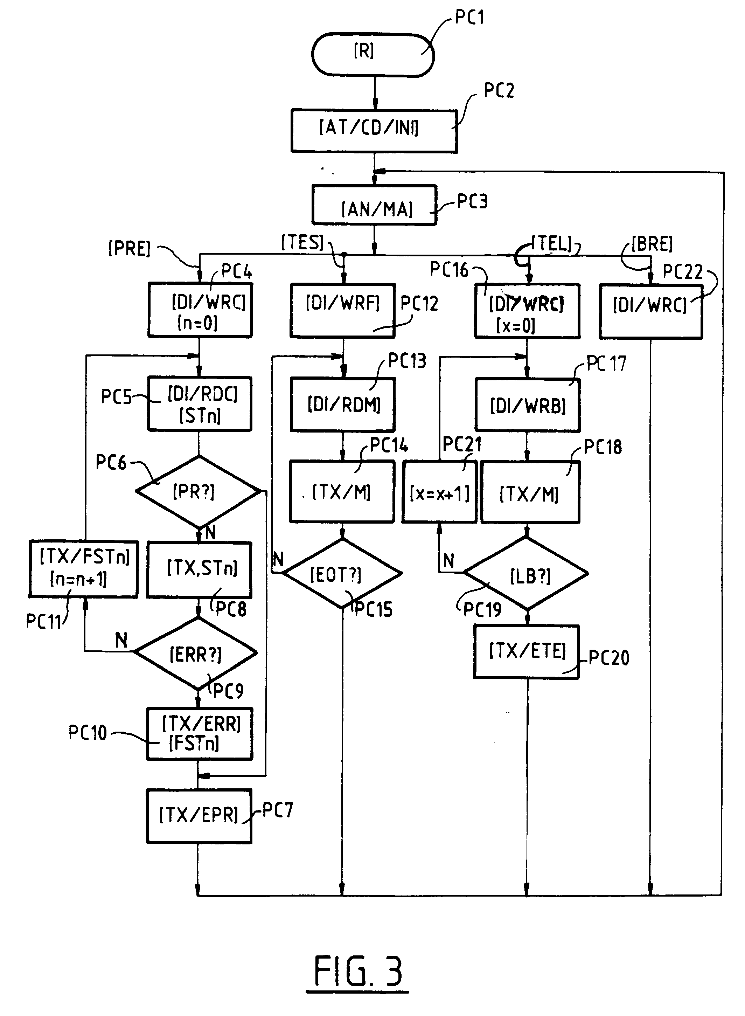

Sur la figure 3 est proposé un exemple de schéma représentant les différentes étapes parcourues pour la mise en oeuvre des tests, ces derniers utilisant les fonctions internes de la carte pilote PC.

La première étape PC1 consiste à effectuer une remise à zéro [R] des mémoires vives lors de la mise sous tension. A l'étape PC2 suivant la mise sous tension, trois fonctions sont utilisées, d'une part la fonction autotest [AT] de la carte PC qui permet de vérifier le bon fonctionnement de ladite carte avec rebouclage sur le sous-test en cours lorsqu'une erreur est rencontrée, d'autre part la fonction affichage du code [CD] grâce à laquelle le numéro de sous-test en cours peut-être visualisé sur l'afficheur DC durant cette séquence d'autotest, alors que la diode électroluminescente EL est alimentée lorsqu'une erreur est détectée et enfin la fonction initilisation [INI] permettant d'initialiser et d'activer l'horloge interne et l'interface avec le microordinateur MC. L'étape PC3 consiste à lancer les fonctions d'analyse et de gestion des trames reçues [AN/MA] qui permettront d'une part d'extraire les données utiles et d'acquitter les trames reçues et d'autre part de procéder à l'aiguillage, vers la phase adéquate du procédé de réparation en fonction de la commande à exécuter. En fonction d'une commande émise par le microordinateur MC, quatre possibilités d'aiguillage s'offrent alors, déroulement du test préliminaire [PRE], des tests automatiques des cartes logiques [TES], du téléchargement des programmes de tests [TEL] lorsque cette gestion est désirée, ou prise en compte et gestion d'une rupture [BRE] lorsque celle-ci est déclenchée. A la mise sous tension, le premier test exécuté est le test préliminaire qui correspond alors à la sélection de la branche [PRE]. Ce test préliminaire permet d'accéder directement à la documentation de réparation du sous-test détecté en erreur puis la boucle de réparation de ce sous-test est exécutée. Ainsi, à la prochaine étape PC4, le dialogue entre la carte pilote PC et l'équipement à réparer RM est établi avec l'écriture de la commande de lancement correspondante émise par le microordinateur MC [DI/WRC] le premier sous-test [n = 0] est initialisé. L'étape suivante PC5, le dialogue étant alors établi avec le microordinateur MC et l'équipement à réparer RM, correspond à la lecture d'une commande reçue avec discrimination du numéro (STn) du sous-test variant de 1 à n [DI/RDC, STn] lors du commencement dudit sous-test. Puis à l'étape PC6 une question est posée : "La commande correspond-elle à une demande de fin de test préliminaire ?" [PR ?]. Si la réponse est oui, c'est l'étape PC7 au cours de laquelle la trame relative à la fin de test préliminaire est encadrée par des caractères de contrôle, puis émise, l'acquittement de ladite trame émise étant attendu et la fin de test préliminaire étant confirmée [TX/EPR] et un retour à l'étape PC3 étant opéré. Si, à l'inverse, la réponse à la question [PR ?] de l'étape PC6 est non, la fonction émission de trames est également lancée à l'étape PC8, la trame relative au début de sous-test STn, étant encadrée par des caractères de contrôle puis émise et son acquittement attendu [TX ; STn]. A l'étape suivante PC9 une nouvelle question est posée : "Le résultat indique-t-il une erreur sur le sous-test STn ?" (ERR ?]. Si la réponse est oui : c'est l'étape PC10 au cours de laquelle la trame relative au sous-test STn est émise après avoir été encadrée par des caractères de contrôle, son acquittement étant attendu, la trame émise signalant qu'une erreur a été détectée au cours du sous-test STn et que ce dernier est terminé [TX/ERR/FSTn]. L'étape subséquente est de nouveau l'étape PC7 pour un passage en mode réparation relatif au test préliminaire, le procédé de réparation entre dans une phase de bouclage sur le sous-test en erreur. Seule une coupure secteur sur la carte à réparer permet de relancer le processus. Il y a alors retour à l'étape PC3.

Lorsqu'à la question [ERR ?] de l'étape PC9 la réponse est non, aucune erreur n'a été détectée dans ce sous-test STn, l'étape suivante est PC11. La trame relative à la fin de sous-test STn et à l'incrémentation n = n + 1 pour le prochain sous-test est émise après avoir été encadrée par des caractères de contrôle et son acquittement attendu [TX/FSTn, n = n + 1], puis il y a retour à l'étape PC5. Pour résumer, la sélection du test préliminaire [PRE] suivie de l'émission de la commande de lancement correspondante assure le dialogue entre la carte pilote PC, l'équipement à réparer RM et le microordinateur MC, la carte pilote émettant des trames qui sont analysées par le microordinateur MC, la carte pilote émettant des trames qui sont analysées par le microordinateur pour que des messages liés auxdites trames soient affichés par l'intermédiaire de l'interface utilisateur et que soit provoqué le passage en mode réparation avec accès direct à une boucle de réparation dès le premier sous-test détecté en erreur alors qu'une mise à jour statistique est automatiquement effectuée. Ce processus est applicable également au cas d'une sélection de la branche [TES] lorsque celle-ci est opérée à la fin de l'étape PC3.

A la fin de l'étape PC3, la branche [TES] peut donc être sélectionnée sur demande du microordinateur MC, ce qui entraîne l'étape PC12 qui consiste également à établir le dialogue entre la carte pilote PC, qui écrit une trame émise par le microordinateur MC [DI/WRF], le microordinateur MC et l'équipement à réparer RM, puis le dialogue continuant à l'étape PC13, un message du microordinateur MC est lu par la carte pilote PC [DI/RDM]. L'étape suivante PC14 active la fonction émission trame, la trame relative au message étant encadrée par des caractères de contrôle puis émise et son acquittement attendu [TX/M]. A l'étape PC15 une question est posée : "Le message correspond-il à une observation de fin de test ?" [EOT ?]. Si la réponse est oui, l'étape suivante est de nouveau l'étape PC3. Si la réponse est non, il y a retour à l'étape PC13 et aux suivantes. Les messages liés aux trames sont également dans ce cas affichés par l'intermédiaire de l'interface utilisateur et le passage en mode réparation est provoqué avec accès à un menu de bouclage dès la fin d'un test lorsqu'une erreur a été détectée alors qu'une mise à jour statistique est automatiquement effectuée. En outre, le dialogue pendant les tests entre le microordinateur MC et la carte pilote PC est réservé pour les demandes d'options, utilisées pour le passage de paramètres nécessaires au test en mémoire M de la carte CPU ou pour le résultat d'un sous-test si le programme de test en mémoire M ne peut détecter l'erreur. De cette manière, la trame reçue en retour est lue, le dialogue continuant, la trame de retour donnant le résultat de l'analyse du sous-test réalisée par le microordinateur MC.

A la fin de l'étape PC3, la branche [TEL] peut être sélectionnée sur demande du microordinateur MC, ce qui entraîne l'étape PC16 consistant aussi à établir le dialogue entre la carte pilote PC, qui écrit une commande relative à un bloc à télécharger [DI/WRC], le microordinateur et l'équipement à réparer RM, le premier bloc [x = 0] est initialisé. Puis le dialogue continue, et à l'étape PC17 la carte pilote PC écrit le bloc x, x variant de 1 à x [DI/WRB]. L'étape suivante PC18 active la fonction émission trame, la trame relative au message étant encadrée par des caractères de contrôle puis émise et son acquittement attendu [TX/M]. A l'étape PC 19 une question est posée : "le dernier bloc a-t-il été écrit ?" [LB ?]. Si la réponse est oui, c'est l'étape PC 20 au cours de laquelle la trame relative à la fin de téléchargement est encadrée par des caractères de contrôle puis émise et son acquittement attendu [TX/ETE], puis il y a retour à l'étape PC3. Si, par contre, la réponse à la question [LB ?] de l'étape PC19 est négative, le numéro de bloc est incrémenté d'une unité [x = x + 1] à l'étape PC21, puis il y a retour à l'étape PC17 et ainsi de suite jusqu'au dernier bloc.

A la fin de l'étape PC3, la branche [BRE] peut en outre être sélectionnée sur demande du microordinateur MC, ceci entraîne l'étape PC22 consistant dans ce cas à établir le dialogue avec la carte pilote PC qui écrit une commande de rupture émise par le microordinateur MC [DI/WRC], puis il y a retour à l'étape PC3.

Sur la figure 4 est proposé un exemple de schéma représentant les différentes étapes parcourues pour le déroulement du procédé de réparation mis en oeuvre par l'outil de maintenance et d'aide à la réparation.

Le procédé selon l'invention est remarquable en ce que, en premier lieu est opérée une sélection du type de test, test préliminaire, tests automatiques ou tests manuels, d'une part, suivie dans le cas d'un test préliminaire ou de tests automatiques de l'émission de la commande de lancement correspondante assurant le dialogue par l'intermédiaire de la carte pilote, cette dernière émettant alors des trames qui sont analysées par le microordinateur pour que des messages liés auxdites trames soient affichés par l'intermédiaire de l'interface utilisateur et que soit provoqué le passage en mode réparation, soit pour le test préliminaire avec accès direct à une boucle de réparation dès le premier sous-test détecté en erreur, soit pour les tests automatiques avec accès à un menu de bouclages dès la fin d'un test si une erreur a été détectée, alors qu'une mise à jour statistique est automatiquement effectuée dans les deux cas lorsqu'un test est détecté "réparé" d'autre part suivie dans le cas de tests manuels de l'affichage par l'intermédiaire de l'interface utilisateur d'un diagramme des opérations successives à effectuer et de l'affichage pour examen de la documentation de réparation et des statistiques correspondantes, alors que la mise à jour des statistiques est effectuée par appel d'un menu spécifique aux tests manuels.

Comme cela a été précisé précédemment, le procédé de réparation et les fichiers de messages système sont de préférence contenus dans une disquette utilisée avec le microordinateur MC.

A l'étape E1, une commande de lancement de test [CT] est émise vers la carte pilote PC. A l'étape E2 suivante, une question est posée : "La trame fin de test émise par la carte pilote a-t-elle été complètement reçue ?" [ETR ?]. Cette étape est une étape d'attente, c'est-à-dire que tant qu'une trame émise par la carte PC n'a pas été complètement reçue, donc pour une réponse négative à la question [ETR ?], il y a retour au début de l'étape E2. Ainsi, la réception se faisant par caractères,l'étape d'attente permet de garantir qu'une trame a été complètement reçue avant de l'analyser. Une réponse positive à la question [ETR ?] de l'étape E2 entraîne l'étape E3 au cours de laquelle la trame reçue est analysée [ARF]. A l'étape E4 suivante est posée la question : "Une erreur a-t-elle été trouvée pendant le déroulement du test ?" [ERR ?]. Si une erreur a été trouvée, celle-ci est mémorisée à l'étape E5 et placée dans la fenêtre prévue à cet effet sur l'écran de l'interface utilisateur [MWE]. Puis une autre question est posée à l'étape E6 : "L'erreur trouvée est-elle fatale ?" [FER ?]. Une réponse négative à cette question provoque un retour à l'étape E2. Si par contre l'erreur trouvée est considérée fatale, l'étape E7 qui suit consiste à activer la fenêtre erreur [WEA], c'est le passage en mode réparation.

Lorsqu'à la question [ERR ?] de l'étape E4, la réponse est négative, une autre question est posée à l'étape E8 : "Le message d'acquittement de fin de test a-t-il été reçu ?" [ETM ?]. Ce message est envoyé par la carte pilote PC à la suite d'une réponse positive à la question [EOT ?] posée à l'étape PC16 décrite avec la figure 3. Une réponse négative à la question [ETM ?] de l'étape E8 provoque également un retour à l'étape E2 alors qu'une réponse positive entraîne une autre question à l'étape E9 : "Le test est-il toujours trouvé en erreur ?" [EIT ?]. Si la réponse est non, la question suivante est posée à l'étape E10 : "Le test est-il détecté "réparé" sur la carte ?" [TRC ?]. Une réponse positive entraîne l'étape E11 au cours de laquelle est réalisée une demande de mise à jour statistique de la carte testée [UDS] puis l'étape E12 marquant la fin du test [TO]. De même une réponse négative à la question [TRC ?] de l'étape E10 provoque la fin de test [TO] et par conséquent le passage à l'étape E12.

Lors du traitement en mode réparation, la suite logique de l'activation de la fenêtre erreur [WEA] de l'étape E17 est le passage à l'étape E13 au cours de laquelle une erreur probable est sélectionnée [SOE] dans le menu de la boucle de réparation. A l'étape suivante E14, une commande de lancement de bouclage pour tester l'erreur sélectionnée est émise sous la forme d'une trame [CLE]. Puis à l'étape E15, la fenêtre sur l'écran de l'interface utilisateur relative à la documentation de réparation est activée [WDA]. Ensuite vient la phase de gestion de la documentation de réparation pendant laquelle sont proposés entre autres, des tests, une aide à la réparation et une consultation des statistiques. Cette phase débute avec l'étape E16 correspondant à l'examen de la documentation sur l'écran [DOC]. A cet instant est posée la question suivante à l'étape E17 autorisant une gestion avantageuse de la documentation : "Un changement de fenêtre active est-il désiré ?" [CAW ?]. Une réponse positive à cette question permet à l'étape E18, à l'utilisateur de faire une sélection parmi un choix de fenêtres proposé en activant la fenêtre désirée [WWA]. La sélection peut par exemple être faite parmi des fenêtres spécifiques "aide", consultation "statistique", "documentation de réparation", "erreur", "message", etc ... . La sélection de fenêtre opérée, lorsque l'utilisateur a fini de consulter ladite fenêtre, il y a retour à l'étape E16.

Si la réponse à la question [CAW ?] de l'étape E17 est négative, une autre question est posée à l'étape E19 : "La fermeture de la session de réparation est-elle désirée ?" [COR ?]. Une réponse négative à cette question entraîne un retour à l'étape E16, alors qu'une réponse positive conduit à l'étape E20 au cours de laquelle une commande de rupture est émise vers la carte pilote [BRC]. Puis, à l'étape E21 le microordinateur MC attend le signal permettant de réaliser la synchronisation avec la carte pilote PC [SYP]. Enfin, il y a passage à l'étape E10 suivie soit directement de l'étape E12, soit des étapes E11 et E12.

Suivent quelques précisions relatives à l'interface utilisateur qui permettront de mieux apprécier l'efficacité et la facilité d'utilisation du procédé et de l'outil selon l'invention.

Selon une application préférée, la mise en oeuvre du procédé de réparation nécessite l'installation d'une première disquette contenant les fichiers de configuration pour un produit donné, ce qui rend le procédé universel et d'une seconde disquette contenant le procédé de réparation et les fichiers de message système, ces disquettes n'étant pas protégées en écriture. Il suffit alors d'exécuter les commandes et de suivre les indications fournies à l'écran lors du déroulement du procédé. Lors du chargement en mémoire, une phase de configuration du système initialise les structures nécessaires au bon fonctionnement du procédé (création de tables de messages, erreurs, ...). Les différents fichiers sont sélectionnés, les listes de machines, les cartes (dont les fichiers ont déjà été installés) ainsi que les langages (français, anglais, ...) étant affichés sur l'écran. En outre, un historique des pannes est mémorisé dans le superviseur pour chaque carte. Le numéro de série de la carte est saisi, ce qui permet d'assurer le suivi des cartes et d'automatiser l'appel aux fonctions d'actualisation des statistiques. Les procédures de test sont divisées en deux catégories : les tests de réparations (unitaires et chaînages automatiques) et les tests d'endurance (chaînages manuels).

Dans le cas du chaînage automatique, tous les tests sont exécutés en séquence, les bouchons de terminaison de test doivent être présents avant le lancement de la procédure. les erreurs sont mémorisées dans la fenêtre "erreur" pendant le processus de test. En fin de procédure, pour accéder à la réparation, le fenêtre "erreur" est activée, l'erreur correspondante au test exécuté est sélectionnée. Puis un menu de bouclage est proposé, chaque choix met en oeuvre une boucle de réparation et une documentation spécifique. Les statistiques sont actives. La réparation nécessite au moins deux passages de tests. Un premier passage pour la détection et la réparation de la carte, un second passage pour le contrôle du bon fonctionnement de la carte. Les statistiques sont automatiquement appelées pour tous les tests détectés en erreur au premier passage. Le nombre de passage pour la réparation est un critère de qualité.

Concernant les tests unitaires, la procédure de test et de réparation est identique à celle mise en oeuvre par le chaînage automatique mais pour un test uniquement.

En outre, des tests d'endurance peuvent être utilisés pour détecter des pannes aléatoires ou pour valider une carte en endurance. Dans ce cas, il n'est pas accédé au menu de réparation et les statistiques ne sont pas actives. Une table est disponible pour consulter les résultats du dernier test d'endurance exécuté. Cette table fournit pour chaque test effectué le nombre de passages ainsi que le dernier état connu. Le réparateur utilisera le chaînage manuel afin de rendre permanentes les pannes aléatoires, pour cela il pourra utiliser différents moyens mis à sa disposition (souflette d'air chaud, bombe réfrigérante, vibrations, ...).

Pour réaliser un diagnostic, la carte est découpée en tests fonctionnels, chaque test contenant différents sous-tests. Le sous-test est l'élément de base du procédé pour chacun d'eux, son titre et son état sont affichés dans la fenêtre "message". Si une erreur est détectée, son libellé est affiché dans la fenêtre "erreur". Lorsqu'une erreur fatale est détectée, le test est abandonné.

Concernant la réparation, les erreurs présentes dans la fenêtre "erreur" sont utilisées pour avertir l'utilisateur qu'une erreur a été détectée et pour accèder au menu de réparation. Lorsque cette fenêtre est activée, le superviseur affiche l'erreur courante en vidéo inverse, les flèches permettant de sélectionner une autre erreur présente dans la fenêtre.

Sur validation, le superviseur affiche un menu de réparation lié au test en erreur, le numéro de sous-test détermine le choix le plus approprié du menu à faire clignoter indiquant ainsi le bouclage de réparation le plus adapté.

Chaque choix du menu exécute une boucle de réparation spécifique et affiche la documentation de réparation. Les autres informations, documentation d'aide du test, table de composants pouvant être défectueuses, les diverses fenêtres (messages, erreurs, ...) sont toujours accessibles.

Une fonction autoformation est également disponible. Il est accédé à cette fonction afin d'exécuter les procédures de réparation sans qu'une erreur ne soit détectée ou pour comparer une carte référence avec une carte à réparer.

Les exigences en matière de compatibilité et de portabilité dans le domaine de la réparation et dans un contexte international imposent la conception d'un procédé reposant sur le paramétrage et la modularité. Le paramétrage proposé se veut le plus convivial possible, à partir de listes (machines, cartes, langages), le système se configure avec les fichiers spécifiques à ce procédé qui est appliqué en tenant compte d'un certain nombre de fonctions de base regroupées dans différents modules selon leur utilisation. Les différents modules suivants sont ainsi distingués :
- point d'entrée du système d'exploitation,
- chargement du procédé pour chaque matériel en mémoire,
- menu de programme,
- gestion des fichiers pour le procédé appliqué à un matériel,
- fenêtres utilisateur,
- protocole de dialogue vers la carte pilote,
- statistiques,
- erreurs et procédures de réparation,
- affichage dans les fenêtres utilisateur,
- documentation "aide et réparation",
- chaînage manuel, ... .

Pour conclure, l'utilisation de l'outil de maintenance et d'aide à la réparation et du procédé de mise en oeuvre par ledit outil permet d'atteindre de manière aisée et efficace un grand nombre d'objectifs fixés actuellement en répondant aux exigences suivantes.

### * La réparation décentralisée :

Pouvoir réparer au meilleur coût en tout point du globe, le plus près possible de l'utilisateur final permet de :
- Diminuer les stocks et les approvisionnements en pièces de rechange et par conséquent de diminuer les frais financiers,
- Diminuer les coûts de réparation en évitant la sous-traitance et ses abus,
- Supprimer les "pipelines" de réparation, les coûts logistiques, les coûts de transport, de douane, ... ,
- Maintenir à bon compte une compétence technique et apporter ainsi un service de qualité à la clientèle,
- Mettre en oeuvre le processus d'amélioration de la qualité ou la mesure immédiate du comportement des produits, la quantification et l'identification des défauts alertant avec la meilleure réactivité, cela dès la période de démarrage, au moment où l'expérience manque.

### * La performance technique :

C'est elle qui intervient en premier chef dans la réduction des coûts de réparation.

La performance technique s'appuie sur la notion de temps mis pour réparer une carte et sur la capacité que le procédé a à détecter les pannes.

Le procédé de réparation selon l'invention est en outre universel, s'adaptant à tout type d'équipement électronique de traitement de l'information, puisqu'il s'applique avantageusement et sans difficulté à un outil standard.

### * L'ergonomie convivialité :

Ces caractéristiques sont aujourd'hui l'apanage de la micro-informatique. C'est parce qu'elles interviennent sur son rendement que le technicien devient exigeant, et si l'outil proposé n'offre pas une interface facile, agréable, efficace, cet outil est vite abandonné. Ici, toute la documentation est intégrée au logiciel et accessible à tout moment.

### * Utilisable par des non spécialistes en tout point du globe :

En effet, devant la variété croissante des produits arrivant sur le marché de la grande diffusion informatique, il est impensable de former le réparateur sur les gammes aussi étendues que sont les terminaux, les stations, les micros. Le réparateur doit aujourd'hui entrer dans le processus, guidé par le programme, et disposer de tous les moyens permettant un diagnostic précis et rapide (documentation, statistiques, historique).

Par ailleurs, pour répondre aux contextes géopolitiques locaux, il faut que les méthodes soient efficaces dans chacune des filiales et cela malgré leur diversité. Les concepts intégrés au processus conduisent à l'enrichissement du réparateur sans effort particulier.

### * Investissement le plus faible possible :

Le procédé permet de mieux maîtriser les coûts et investissements tant en terme de développement au niveau étude qu'en terme utilisateur au niveau de chaque réparateur, tout nouveau développement est vu sous l'angle de l'adaptation et de l'amélioration des performances.

### * Disponibilité gage de qualité :

Pour être efficace et bien utilisé, le procédé de réparation doit être disponible au moment où le produit pour lequel il est fait est mis sur le marché.

C'est le moment où les problèmes de "jeunesse" déterminent l'avenir du produit. A travers le procédé de réparation peuvent être détectés, mesurés très vite et très tôt les défauts qui s'ils ne sont pas corrigés rapidement, obèrent l'avenir du produit.

### * Maîtriser la fin de vie des produits :

S'il est fondamental de réussir le début de commercialisation d'un produit, la période qui en suit son arrêt est tout aussi importante.

La réparation est un atout essentiel pour la maintenance, elle doit rester performante même quand les fournisseurs, les fabricants ont disparu.

## Revendications

1. Procédé de réparation d'équipements électroniques (RM) de traitement de l'information mis en oeuvre par un outil de maintenance et d'aide à la réparation utilisant des programmes de tests implantés en mémoire sur la carte comportant l'unité centrale (CPU) de traitement de l'équipement à réparer et comportant, entre autres, des moyens logiciels fonctionnant sur un microordinateur (MC) présentant une interface utilisateu (UI) et et relié à la carte comportant l'unité centrale de traitement par l'intermédiaire d'une voie de télécommunication (TC) standard et des moyens matériels comprenant principalement une carte pilote (PC), un adaptateur de bus (BA) et des bouchons de terminaison de test, caractérisé en ce que pour l'identification du plus petit composant de test, changeable, en premier lieu est opérée une sélection du type test préliminaire, tests automatiques ou tests manuels, d'une part, suivie dans le cas d'un test préliminaire ou de tests automatiques de l'émission de la commande de lancement correspondante assurant le dialogue par l'intermédiaire de la carte pilote (PC), cette dernière émettant alors des trames de données qui sont analysées par le microordinateur (MC) pour que des messages liés auxdites trames soient affichés par l'intermédiaire de l'interface utilisateur (UI) et que soit provoqué le passage en mode réparation, soit pour le test préliminaire avec accès direct à une boucle de réparation dès le premier sous-test détecté en erreur, soit pour les tests automatiques avec accès à un menu de bouclages dès la fin d'un test si une erreur a été détectée, alors qu'une mise à jour statistique est automatiquement effectuée dans les deux cas lorsqu'un test est détecté "réparé" d'autre part suivie dans le cas de tests manuels de l'affichage par l'intermédiaire de l'interface utilisateur d'un diagramme des opérations successives à effectuer et de l'affichage pour examen de la documentation de réparation et des statistiques correspondantes, alors que la mise à jour des statistiques est effectuée par appel d'un menu spécifique aux tests manuels.

2. Outil de maintenance et d'aide à la réparation mettant en oeuvre le procédé selon la revendication 1, caractérisé en ce que la carte pilote (PC) fonctionne en mode asynchrone et comporte des moyens (SI) pour adapter la liaison série (TC) du microordinateur (MC) recevant les moyens logiciels en un bus parallèle pour la connexion à l'équipement à réparer (RM) et des moyens de gestion d'un premier niveau de protocole entre le microordinateur (MC) recevant les moyens logiciels et ladite carte pilote et d'un second niveau de protocole entre ladite carte pilote (PC) et l'équipement à réparer (RM).

3. Outil de maintenance et d'aide à la réparation selon la revendication 2, caractérisé en ce que les moyens logiciels fonctionnant sur le microordinateur (MC) comportent des moyens de stockage dynamiques contenant des fichiers de configuration, des fichiers de messages système et le procédé de réparation coopérant pour élaborer différentes fenêtres, interrogeables par l'intermédiaire de l'interface utilisateur et informant sur les opérations en cours, et pour présenter un menu de bouclages automatiquement proposé à l'utilisateur après détection d'un test en erreur ou sur activation d'une erreur déjà présente dans sa fenêtre.

4. Outil de maintenance et d'aide à la réparation selon la revendication 3, caractérisé en ce que des circuits de mémoire spécifiques (M), enfichables sur la carte comportant l'unité centrale de traitement de l'équipement à réparer, contiennent les programmes de tests qui contrôlent les différents ensembles fonctionnels, chacun de ces ensembles constituant un test, chaque test étant décomposé en sous-tests correspondant au contrôle d'une erreur spécifique au moyen d'une boucle de réparation, alors qu'un test préliminaire est réalisé à chaque mise sous tension pour diagnostiquer et réparer le noyau minimum nécessaire d'une part à l'accès d'une zone mémoire autorisant les différents autres tests et d'autre part pour assurer le dialogue avec le microordinateur par l'intermédiaire de la carte pilote.

5. Outil de maintenance et d'aide à la réparation selon l'une des revendications précédentes, caractérisé en ce que la carte pilote comporte en outre des moyens de stockage contenant des microprogrammes commandant différentes fonctions internes parmi lesquelles la fonction autotest effectuée, à la mise sous tension, le test du fonctionnement de ladite carte avec rebouclage sur le sous-test en cours lors de la détection d'une erreur, la fonction d'affichage du code effectue la gestion de moyens d'affichage pour indiquer le numéro de sous-test ainsi que l'apparition d'une erreur durant la séquence d'autotest, la réception d'une commande d'abandon d'un test ou d'un bouclage et la détection d'une erreur sur une donnée reçue de ou à transmettre vers l'extérieur, la fonction initialisation initialise et active l'horloge interne, l'interface avec le microordinateur ou une interruption en réception, la fonction gestion de trames effectue l'extraction des données utiles et l'acquittement des trames reçues, la fonction analyse de trames procède à l'aiguillage vers les différentes phases du procédé de réparation en fonction de la commande à exécuter, la fonction émission de trames opère l'encadrement par des caractères de contrôle des trames, l'émission des trames ainsi que l'attente d'acquittement des trames émises et la fonction dialogue procède à l'échange d'informations au travers d'une boîte à lettres accessible en lecture et en écriture.

## Patentansprüche

1. Verfahren zum Reparieren elektronischer Informationsverarbeitungsanlagen (RM), das durch ein Wartungs- und Reparaturhilfswerkzeug ausgeführt wird, das seinerseits Prüfprogramme verwendet, die in einem Speicher auf der die Zentraleinheit (CPU) der zu reparierenden Anlage enthaltenden Karte abgelegt sind, und unter anderem Software-Mittel, die auf einem Mikrocomputer (MC) ausgeführt werden, der eine Anwenderschnittstelle (UI) aufweist und mit der die Zentraleinheit enthaltenden Karte über einen Standard-Telekommunikationsweg (TC) verbunden ist, sowie Hardware-Mittel enthält, die hauptsächlich eine Steuerkarte (PC), eine Busanpassungseinrichtung (BA) und Prüf-Abschlußstecker enthalten, dadurch gekennzeichnet, daß für die Identifizierung des kleinsten veränderbaren Prüfbauelements zunächst eine Wahl des Typs Vorprüfung, automatische Prüfungen oder manuelle Prüfungen erfolgt, der einerseits, im Fall einer Vorprüfung oder von automatischen Prüfungen, der entsprechende Freigabebefehl folgt, der den Dialog über die Steuerkarte (PC) sicherstellt, wobei diese letztere dann Rahmen von Daten aussendet, die vom Mikrocomputer (MC) analysiert werden, damit die mit den Rahmen verbundenen Nachrichten über die Anwenderschnittstelle (UI) angezeigt werden und damit der Übergang in den Reparaturbetrieb bewirkt wird, entweder für die Vorprüfung mit direktem Zugriff auf eine Reparaturschleife ab der ersten einen Fehler aufzeigenden Unterprüfung oder für die automatischen Prüfungen mit Zugriff auf ein Schleifenmenü ab dem Ende einer Prüfung, falls ein Fehler erfaßt worden ist, während in den beiden Fällen automatisch eine statistische Aktualisierung erfolgt, wenn eine Prüfung den "reparierten" Zustand erfaßt, und der andererseits, im Fall der manuellen Prüfungen, die Anzeige eines Diagramms der nacheinander auszuführenden Operationen sowie die Anzeige für die Untersuchung der Reparaturdokumentation und der entsprechenden Statistiken über die Anwenderschnittstelle folgen, während die Aktualisierung der Statistiken durch Aufruf eines für die manuellen Prüfungen spezifischen Menüs erfolgt.

2. Wartungs- und Reparaturhilfswerkzeug, das das Verfahren nach Anspruch 1 ausführt, dadurch gekennzeichnet, daß die Steuerkarte (PC) im asynchronen Modus arbeitet und Mittel (SI) für die Anpassung der seriellen Verbindung (TC) des die Software-Mittel empfangenden Mikrocomputers (MC) an einen parallelen Bus für den Anschluß der zu reparierenden Anlage (RM) sowie Mittel zum Steuern einer ersten Protokollebene zwischen dem die Software-Mittel empfangenden Mikrocomputer (MC) und der Steuerkarte und einer zweiten Protokollebene zwischen der Steuerkarte (PC) und der zu reparierenden Anlage (RM) enthält.

3. Wartungs- und Reparaturhilfswerkzeug nach Anspruch 2, dadurch gekennzeichnet, daß die Software-Mittel, die im Mikrocomputer (MC) ausgeführt werden, dynamische Speichermittel umfassen, die Konfigurationsdateien und SystemnachrichtenDateien enthalten, wobei das Reparaturverfahren so arbeitet, daß es verschiedene Fenster erzeugt, die über die Anwenderschnittstelle abfragbar sind und über die laufenden Operationen informieren, und daß es ein Schleifenbildungsmenü darstellt, das dem Anwender nach der Erfassung einer einen Fehler ergebenden Prüfung oder auf die Aktivierung eines im Fenster bereits vorhandenen Fehlers automatisch vorgeschlagen wird.

4. Wartungs- und Reparaturhilfswerkzeug nach Anspruch 3, dadurch gekennzeichnet, daß die spezifischen Speicherschaltungen (M), die in die die Zentraleinheit der zu reparierenden Anlage enthaltende Karte eingesteckt werden können, die Prüfprogramme enthalten, die die verschiedenen funktionalen Einheiten steuern, wobei jede dieser Einheiten eine Prüfung bildet, wobei jede Prüfung in Unterprüfungen zerlegt ist, die der Kontrolle eines spezifischen Fehlers mittels einer Reparaturschleife entsprechen, während bei jedem Einschalten eine Vorprüfung ausgeführt wird, um den kleinsten Kern, der einerseits für den Zugriff auf eine die verschiedenen anderen Prüfungen zulassende Speicherzone und andererseits für die Sicherstellung des Dialogs mit dem Mikrocomputer über die Steuerkarte notwendig ist, zu diagnostizieren und zu reparieren.

5. Wartungs- und Reparaturhilfswerkzeug nach einem der vorangehenden Ansprüche, dadurch gekennzeichnet, daß die Steuerkarte außerdem Speichermittel umfaßt, die Mikroprogramme enthalten, die verschiedene interne Funktionen steuern, von denen die Selbstprüfungsfunktion beim Einschalten die Funktionsprüfung der Karte mit Rückschleifung zur laufenden Unterprüfung bei Erfassung eines Fehlers ausführt, die Codeanzeigefunktion die Steuerung der Anzeigemittel für die Angabe der Nummer der Unterprüfung sowie des Auftretens eines Fehlers während der Selbstprüfungsfolge, den Empfang eines Befehls zum Aufgeben einer Prüfung oder einer Schleifenbildung sowie die Erfassung eines Fehlers in einer von außen empfangenen oder nach außen zu übertragenden Dateneinheit ausführt, die Initialisierungsfunktion den internen Takt, die Schnittstelle mit dem Mikrocomputer oder eine Unterbrechung beim Empfang initialisiert und aktiviert, die Rahmensteuerungsfunktion die Entnahme der Nutzdaten und die Quittierung der empfangenen Rahmen ausführt, die Rahmenanalysefunktion mit dem Übergang zu den verschiedenen Phasen des Reparaturverfahrens in Abhängigkeit vom auszuführenden Befehl fortfährt, die Rahmensendefunktion die Einfassung der Rahmen durch Steuerzeichen, das Senden der Rahmen sowie das Erwarten der Quittierung der ausgesendeten Rahmen bewirkt und die Dialog funktion mit dem Austausch von Informationen über einen beim Lesen und Schreiben zugänglichen Briefkasten fortfährt.

## Claims

1. A process for repairing electronic information-processing equipment (RM) implemented by a maintenance and repair-aid tool using test programs installed in memory on the board comprising the central processing unit (CPU) of the equipment to be repaired and including, inter alia, software means operating on a microcomputer (MC) having a user interface (UI) and connected to the board comprising the central processing unit via a standard telecommunications channel (TC) and hardware means comprising principally a pilot board (PC), a bus adapter (BA) and test termination plugs, characterised in that, to identify the smallest interchangeable test component, a selection is first made of the preliminary test, automatic test or manual test type on the one hand, followed in the case of a preliminary test or automatic tests by the transmission of the corresponding launch command providing the dialogue via the pilot board (PC), the latter then transmitting frames of data which are analysed by the microcomputer (MC) so that messages linked to said frames are displayed via the user interface (UI) and so that the change to repair mode is provoked, either for the preliminary test with direct access to a repair loop starting from the first sub-test detected in error, or for the automatic tests with access to a menu of loops starting from the end of a test if an error has been detected, while a statistical update is automatically effected in both cases when a test is detected as "repaired" on the other hand, followed in the case of manual tests by the display via the user interface of a diagram of the successive operations to be effected and by the display for examination of the repair documentation and corresponding statistics, while the updating of the statistics is effected by calling up a menu specific to the manual tests.

2. A maintenance and repair-aid tool implementing the process according to Claim 1, characterised in that the pilot board (PC) operates in asynchronous mode and includes means (SI) for adapting the serial link (TC) of the microcomputer (MC) receiving the software means to a parallel bus for connection to the equipment to be repaired (RM) and means for managing a first level of protocol between the microcomputer (MC) receiving the software means and said pilot board and a second level of protocol between said pilot board (PC) and the equipment to be repaired (RM).

3. A maintenance and repair-aid tool according to Claim 2, characterised in that the software means functioning on the microcomputer (MC) include dynamic storage means containing configuration files, system message files and the repair process co-operating in order to formulate various windows that can be interrogated via the user interface and that give information on current operations, and in order to present a menu of loops automatically offered to the user after the detection of an erroneous test or on the activation of an error already present in its window.

4. A maintenance and repair-aid tool according to Claim 3, characterised in that specific memory circuits (M), capable of being plugged into the board comprising the central processing unit of the equipment to be repaired, contain the test programs which control the various functional assemblies, each of these assemblies constituting a test, each test being broken down into sub-tests corresponding to the checking of a specific error by means of a repair loop, while a preliminary test is performed on each powering up in order to diagnose and repair the minimum core necessary, on the one hand, for access to the memory zone authorising the various other tests and, on the other hand, for ensuring dialogue with the microcomputer via the pilot board.

5. A maintenance and repair-aid tool according to one of the preceding claims, characterised in that the pilot board also comprises storage means containing microprograms controlling different internal functions including the self-test function effected on powering up, the test of the functioning of said board with looping back to the current sub-test when an error is detected, the code display function effects the management of display means so as to indicate the sub-test number and the appearance of an error during the self-test sequence, the reception of a command to abandon a test or a loop and the detection of an error on a datum received from or to be transmitted to the outside, the initialisation function initialises and activates the internal clock, the interface with the microcomputer and an interruption in reception mode, the frame management function effects the extraction of the useful data and the acknowledgement of the frames received, the frame analysis function carries out the routing to the different phases of the repair process as a function of the command to be executed, the frame transmission function operates the surrounding of frames between control characters, the transmission of the frames and the waiting for an acknowledgment of the frames transmitted and the dialogue function proceeds with the exchange of information via a mailbox accessible in read and write mode.
